# DEMANDE DE BREVET EUROPEEN

(11) **EP 4 498 433 A1**
(43) Date de publication de la demande: **29.01.2025**
(21) Numéro de dépôt: 24190547.0
(22) Date de dépôt: 24.07.2024
(51) Int. Cl.: H01L 25/075, H01L 33/50, H01L 33/00, H01L 33/32, H01L 33/56

(54) **ÉCRAN À PIXELS ÉMISSIFS POUR POSTE DE PILOTAGE D'AÉRONEF ET PROCÉDÉ DE REMPLACEMENT D'UN ÉCRAN D'AFFICHAGE DE POSTE DE PILOTAGE D'AÉRONEF PAR UN TEL ÉCRAN À PIXELS ÉMISSIFS**

(30) Priorité: 28.07.2023 FR 2308198
(71) Demandeur: THALES, 92190 Meudon (FR)
(72) Inventeur: TORAILLE, Vincent, 33700 MERIGNAC (FR); KRETZ, Thierry, 33700 MERIGNAC (FR)
(74) Mandataire: Atout PI Laplace

(57) **Abrégé**

Écran à pixels émissifs pour poste de pilotage d'aéronef, comprenant un substrat plan (100) portant une pluralité de diodes électroluminescentes (101, ..., 10n) de même spectre d'émission et dans lequel chaque pixel est constitué d'au moins un groupe compact de plusieurs desdites diodes électroluminescentes. Dans un pixel de l'écran, les diodes électroluminescentes d'un desdits groupes sont recouvertes d'une couche (201, 202, 203; resp. 301, 302, 303) formant une couverture commune auxdites diodes électroluminescentes dudit groupe et relayant une lumière diffuse, avec ou sans photoluminescence, en réaction à l'émission de lumière par les diodes électroluminescentes du groupe. Un matériau (250, resp. 350) à forte densité optique peut avantageusement être placé entre groupes de diodes électroluminescentes. Un procédé de remplacement d'un écran d'affichage de poste de pilotage d'un aéronef, permettant d'installer un écran à pixels émissifs tel que précédemment décrit, est également divulgué.

## Description

### Domaine de l'invention

L'invention concerne le domaine des écrans d'affichage en couleurs pour l'aéronautique, et plus précisément pour les postes de pilotage d'avion ou d'hélicoptère, ainsi que leur conception, et leur évolution au cours de la durée de vie - particulièrement longue - d'un modèle donné d'aéronef.

### Etat de la technique

On s'intéresse en particulier à des écrans pour le poste de commande - ou poste de pilotage - d'un aéronef - avion ou hélicoptère - civil ou militaire, de 3", 10" ou 15" de diagonales, par exemple, ces valeurs de dimension constituant de simples exemples. Ces écrans servent à la navigation, la cartographie, la visualisation de l'horizon artificiel, ou le roulage au sol, notamment, mais d'autres applications existent et sont envisageables, y compris des écrans de 20". Par rapport aux écrans pour les applications grand public, ces écrans pour l'aéronautique doivent résister à des conditions de fonctionnement plus exigeantes, comme des températures élevées (75°C), basses (-40°C), avec des variations de température potentiellement rapides, pouvant être de plusieurs dizaines de °C en une minute. Ces écrans doivent aussi être stockables, en dehors de leur période de fonctionnement, à des températures variant de -55°C à +85°C. Ils doivent résister à une exposition très prolongée à des rayonnements ionisants comme ceux présents aux altitudes où circulent les avions, par exemple 10000 m au-dessus du niveau de la mer, voire parfois plus. Ils doivent avoir une durée de vie en fonctionnement de plusieurs dizaines d'années, et donc avoir une forme d'immunité aux pannes, soit parce qu'aucune panne ne les touche, soit parce que des formes de redondance prennent le relai sur les composants rencontrant des difficultés. Les performances de luminosité doivent également être stables sur la durée de vie mentionnée. Les technologies de fabrication sont donc adaptées à ces exigences, autant sur le plan du choix des matériaux, du châssis, du dimensionnement électrique et mécanique, des choix de dessins des circuits électriques, des choix des composants élémentaires. Les écrans concernés peuvent être placés dans une unité LRU - unité remplaçable en ligne, disposant d'une fonction spécifique, ou être mis en place dans le cadre d'une architecture intégrée, dans une suite avionique.

Ces écrans sont souvent conçus avec la technologie LCD (écran à cristaux liquides). Les écrans à cristaux liquides utilisent les propriétés de bi-réfringence variable de cristaux, dont on fait varier l'orientation en fonction d'un champ électrique. Un rétroéclairage est maintenu en permanence, récemment par des LEDs (diodes électroluminescentes) blanches (mais historiquement, il s'agissait de CCFL - Cold Cathode Fluorescent Lamp ou lampes fluorescentes à cathode froide, encore utilisées couramment de nos jours), et en fonction de l'orientation des cristaux liquides, la lumière est ponctuellement transmise ou non transmise puisque le cristal liquide est placé entre deux polariseurs croisés. Les LEDs blanches peuvent être des LEDs bleues sur lesquelles a été déposé un luminophore dit phosphore jaune (souvent YAG:Ce3+), qui par fluorescence et addition du bleu de la diode non absorbé par le phosphore et du jaune produit par fluorescence donne du blanc.

Ce sont les transistors en couches minces TFT permettant de commander en tension les cristaux liquides qui définissent les pixels. Pour obtenir une coloration, trois cellules de cristaux liquides par pixels sont utilisées, et munies chacune, parallèlement au cristal liquide, d'un filtre coloré rouge, vert ou bleu, ce qui permet, en en allumant une ou plusieurs, d'obtenir la couleur souhaitée, par synthèse additive. Ces filtres sont des filtres passifs, qui absorbent (et en tout cas empêchent la transmission de) certaines longueurs d'onde, et laissent passer d'autres longueurs d'onde, en général par un phénomène de transmission en ligne droite.

Les LEDs de rétroéclairage, qui peuvent faire 2 à 3 mm de largeur, peuvent être naturellement placées en tapis, mais aussi être mises sur le côté (dans une configuration qualifiée de « edge-lit »), avec un guide d'onde planaire par exemple en PMMA (poly méthacrylate de méthyle acrylique ou plexiglas), chargé dans son volume pour diffuser sur le plan ou muni en surface d'une sérigraphie de points diffusants par exemple. Les LEDs de rétroéclairage sont allumées en permanence.

Les technologies d'écran à cristaux liquides LCD, basées sur la transmission et l'occultation d'une lumière présente en permanence en arrière-plan, sont concurrencées par des technologies dans lesquelles de la lumière monochrome ou colorée est émise par des LED, qui sont allumées et éteintes pour produire l'image - on parle de pixels autoémissifs ou émissifs.

Ainsi, par exemple, des écrans OLED, sans cristaux liquides et sans rétroéclairage permanent, connaissent un succès dans le domaine grand public, par exemple dans les smartphones - les pixels peuvent être de 150 µm par exemple. Les OLEDs ou LEDs organiques dont la dimension est de l'ordre de grandeur du pixel sont formées par superposition de plusieurs couches semi-conductrices organiques.

Les OLED peuvent être placées par groupe de LEDs de différentes couleurs, dont une rouge, une verte et une bleue, et il est possible de toutes les éteindre en même temps pour avoir un noir profond. La couleur peut être obtenue nativement par adaptation de la chimie de l'OLED pour obtenir une couleur donnée ou, si les OLEDs émettent une lumière blanche, par l'utilisation de filtres passifs qui absorbent les longueurs d'onde autres que celles qu'il est souhaité conserver pour la LED concernée. Il est aussi possible, dans des modèles récents, de déplacer la longueur d'onde d'émission grâce à un point quantique (quantum dot en anglais, parfois appelé aussi boite quantique), à savoir une structure physico-chimique de très petite taille - des nanocristaux semi-conducteur - capable de photoluminescence ou plus précisément de fluorescence dans une gamme spectrale étroite.

La durée de vie des produits OLEDs semble, à ce jour, insuffisante pour les applications aéronautiques, notamment du fait de la nature organique de la matière des OLEDs.

Plus en avant, les micro-LEDs sont des objets d'émergence récente, d'une part plus petits (jusqu'à aussi peu que 50 µm de largeur, voire moins), utilisant notamment les semi-conducteurs nitrure de gallium-indium InGaN et nitrure de gallium GaN, et offrant des perspectives intéressantes pour le domaine aéronautique, avec des durées de vie anticipées élevées, des temps de réponse très courts, de l'ordre de quelques nanosecondes, ainsi qu'une faible consommation. Les micro-LEDs sont commandées par des circuits CMOS sur silicium ou par des transistors à couches minces TFT et on peut également les trouver sur des supports de circuit imprimé PCB. Par ces circuits de commande, on leur transmet une commande en courant.

Les micro-LEDs chauffent peu, ont une grande luminance, et un temps de réponse court. Leur durée de vie est également avantageuse. Les procédés de fabrication utilisent la déposition des matériaux sur du verre ou des galettes de silicium, par épitaxie, avec des dimensions de moins de 50µm, puis le transfert (transfert de masse) sur une matrice CMOS (par exemple) de certaines micro-LEDs ainsi fabriquées.

Les micro-LEDs peuvent être placées par groupe de trois micro-LEDs colorées ayant chacune une de trois couleurs Rouge (maximum d'émission vers environ 630 nm) Vert (maximum d'émission vers environ 570 nm) et Bleu (maximum d'émission environ 450 nm) ou RVB (RGB en anglais) dans le spectre visible, à proximité les unes des autres dans une disposition d'arrangement horizontal, des arrangements verticaux existant également. Comme elles sont allumées séparément les unes des autres, il est aussi possible de les éteindre simultanément, ce qui offre alors un noir profond, et au final, le contraste est bon.

Pour obtenir ces micro-LEDs colorées, on envisage des micro-LEDs qui soient nativement de différentes couleurs, par ajustement de la nature et/ou de l'épaisseur des couches de semi-conducteur de l'empilement. On peut aussi utiliser des micro-LEDs nativement bleues, connues pour être efficaces énergétiquement et notamment plus efficaces énergétiquement que les micro-LEDs rouges et les micro-LEDs vertes, avec, pour deux micro-LEDs sur trois, un élément actif, photoluminescent, en général fluorescent, éventuellement de type point quantique (aussi appelé boite quantique comme mentionné plus haut -), pour générer, à partir du bleu, soit du vert soit du rouge en fonction de la taille du point quantique, dans les deux cas avec une largeur de raie également assez faible, à mi-pic de 20 à 30 nm.

Pour les cockpits des flottes d'aéronefs existants, la perspective de faire évoluer l'affichage est très faible ou inexistante, car les équipages doivent bénéficier de la même expérience dans chaque appareil, et les normes de sécurité conjuguées aux coûts d'un éventuel changement simultané sur un grand nombre d'appareils en circulation n'ouvrent pas la perspective à une quelconque variation.

Le remplacement des écrans LCD (à CCFL ou LED de rétroéclairage) des appareils en circulation, au fur et à mesure des opérations de maintenance qui sont menées, à la suite par exemple des rares pannes qui se produisent ou lors de maintenance préventive, doit se faire sans que les membres d'équipage ne soient confrontés à un changement de leurs perceptions face à ces écrans.

Ainsi, comme les appareils sont équipés d'écrans LCD avec une résolution donnée, il n'est pas particulièrement envisagé de les remplacer par des écrans à pixels émissifs de résolution supérieure, bien que ceux-ci offrent différents avantages et puissent avoir un coût compétitif. De plus, on peut souhaiter ne pas changer la résolution des flux vidéo qui circulent entre les équipements, ce qui rend a priori inutile la mise en place d'un écran de résolution supérieure.

Néanmoins la mise en place d'écrans à technologie émissive peut néanmoins s'imposer du fait de la raréfaction voire de la rupture des sources d'approvisionnement de tout ou partie des écrans à technologie transmissive. Dans le même ordre idée, et sans aller jusqu'à la rupture de l'approvisionnement des écrans à technologie transmissive, les écrans à technologie émissive peuvent aussi devenir moins chers que les écrans à technologie transmissive, ce qui justifie de chercher à les intégrer dans les avions existants, ou dans les nouveaux exemplaires de modèles certifiés de nombreuses années auparavant, la certification ayant été menée avec des écrans à technologie transmissive.

De manière générale, on souhaite bénéficier de solutions d'évolution des produits existants ne nécessitant que peu de modifications des principes de construction d'une évolution du produit à une autre, pour répondre facilement aux besoins du marché ou des utilisateurs.

Et on souhaite aussi que les produits proposés puissent aisément être maintenus en service même en cas de défaillance d'une diode parmi un grand nombre de diodes, et il est donc souhaité qu'on dispose de solutions pour surmonter une telle défaillance, sans modifier le produit.

L'invention vient dans ce contexte fournir une solution pour fournir des solutions de maintenance aux appareils en circulation basées sur la technologie émissive des écrans à LEDs.

Pour fournir un service adapté, il est proposé un écran à pixels émissifs pour poste de pilotage d'aéronef, comprenant un substrat plan portant une pluralité de diodes électroluminescentes de même spectre d'émission, par exemple des micro-LEDs bleues, et dans lequel chaque pixel est constitué d'au moins un groupe compact de plusieurs desdites diodes électroluminescentes

Ce dispositif est particulier car dans un pixel de l'écran, les diodes électroluminescentes du groupe sont recouvertes d'une couche formant une couverture commune auxdites diodes électroluminescentes dudit groupe et relayant une lumière diffuse, avec ou sans photoluminescence, en réaction à l'émission de lumière par les diodes électroluminescentes du groupe. Il y a en général une couverture pour chaque groupe : la couverture est spécifique au groupe donné.

De par ces caractéristiques, on utilise des produits disponibles, à savoir les micro-LEDs ou toute LEDs de petite taille, et on forme des pixels plus larges, compatibles avec les environnements des postes de pilotage d'aéronefs pour lesquels ils sont destinés, et qui, on l'a dit, compliquent et rendent plus coûteuse si ce n'est impossible la modification de la résolution par rapport aux technologies précédentes. On diminue la consommation énergétique, puisque les écrans à technologie émissive sont moins consommateurs que les écrans de même luminosité fondés sur une technologie transmissive. On fiabilise le produit, en offrant une redondance dans les sources lumineuse, puisque chaque groupe de diodes, formant soit un pixel soit un sous-pixel d'une couleur donnée, est constitué de plusieurs diodes qui, si l'une tombe en panne, peuvent être utilisées pour maintenir le produit en fonctionnement tout aussi excellent, en augmentant la puissance communiquée aux diodes du groupe non défectueuses.

Cela constitue donc une avancée majeure dans le domaine des écrans d'affichage (en couleurs ou monochromes) pour l'aéronautique, puisqu'on peut aussi maintenant mettre en place un écran à pixels émissifs dans différents postes de pilotage d'aéronef, sur la base d'une fourniture de substrats de micro-LEDs de pas très fin, constant, potentiellement imposé par un fournisseur ou par les conditions d'approvisionnement, et avec des résolutions d'écran néanmoins différentes puisqu'il suffit d'adapter l'extension des couches formant couverture dans les deux dimensions du plan de l'écran.

Selon des caractéristiques optionnelles et avantageuses,
- la couche peut comprendre des points quantiques de sorte que la lumière diffusée est de longueur d'onde plus élevée que la lumière reçue des diodes électroluminescentes et que la couche a une émission lumineuse étendue angulairement.

On profite ainsi d'une double propriété des points quantiques : ils modifient la longueur d'onde de la lumière en absorbant la lumière incidente et en émettant une lumière de longueur d'onde plus élevée, et ils émettent cette nouvelle lumière dans un angle solide large - c'est donc une lumière modifiée en longueur d'onde et en directionnalité qui est relayée par la couverture, du fait des points quantiques.
- le pixel peut comprendre plusieurs groupes de diodes électroluminescentes, et pour chaque groupe du pixel, une couche de propriété colorimétrique spécifique (photoluminescente ou non, notamment) recouvre les diodes électroluminescentes dudit groupe formant une couverture propre à chacun des groupes. On peut alors procéder à un affichage par synthèse additive, ce qui ouvre la voie à une grande variété de couleurs.
- la couche de l'un desdits plusieurs groupes de diodes électroluminescentes peut comprendre une charge diffusante et être sans propriété photoluminescente. Dans ce cas, la couverture diffuse une lumière de la même couleur que celle des diodes, à savoir en général une lumière bleue.
- le pixel peut comprendre un groupe rouge, un groupe vert et un groupe bleu. Les groupes rouge et vert sont formés par la présence de points quantiques choisis pour fluorescer une lumière rouge et respectivement une lumière verte dans les couvertures associées aux groupes concernés.

L'écran peut ainsi être un écran couleurs offrant une très large gamme de couleurs par synthèse additive de groupes verts, rouges et bleus. Les groupes des trois couleurs sont formés par l'association, pour chacun d'entre eux, d'une couche de couverture avec les diodes sous-jacentes pour fournir la couleur souhaitée.

Mais l'écran peut aussi être un écran d'unité de contrôle de vol monochrome, vert si chaque pixel comprend un seul groupe, et que les couches de couverture associées fournissent, par association avec les diodes sous-jacentes, une lumière verte.
- les diodes électroluminescentes peuvent être des diodes à base de nitrure de galium dites micro-LEDs. Elles consomment peu d'énergie et ont une durée de vie longue.
- les diodes électroluminescentes peuvent être des diodes bleues, qui sont particulièrement efficaces sur le plan énergétique.
- chaque groupe de diodes peut être constitué par le rapprochement de substrats carrés de diodes électroluminescentes comprenant neuf diodes en trois rangées de trois diodes, et plus généralement, chaque groupe peut être constitué par le rapprochement de substrats rectangulaires de diodes électroluminescentes comprenant des diodes en plusieurs rangées.
- un matériau à forte densité optique peut être placé entre les groupes de diodes, ce qui permet d'éviter l'illumination d'une couverture par les diodes de la couverture voisine.
- la couche colorée peut avoir été déposée par jet d'encre ou sérigraphie, ou d'autres méthodes.
- la couche colorée peut former un encapsulage des diodes, ou être placée sur une couche de verre collée aux diodes.
- la couche formant couverture peut comprendre des points quantiques ou des phosphores pour définir sa couleur, ce qui est compatible avec le fait que toutes les diodes peuvent être de même nature, la longueur d'onde de leur lumière étant modifiée par la couche formant couverture.
- la couche peut comprendre des granules de phosphore ou des points quantiques, et chaque pixel peut comprendre également un groupe de plusieurs diodes électroluminescentes commandées recouvertes d'une couche diffusante essentiellement non teintée commune auxdites plusieurs diodes électroluminescentes du groupe, qui permet de diffuser la lumière native des diodes électroluminescentes, qui sont par exemple des diodes bleues.

L'invention propose aussi un procédé de remplacement d'un écran d'affichage de poste de commande d'un aéronef, comprenant une étape de dépose d'un écran par exemple à cristaux liquides avec rétroéclairage, et une étape de remplacement) dudit écran par un écran de résolution identique à la résolution dudit écran à cristaux liquides.

Le procédé est remarquable car l'écran de résolution identique est choisi comme un écran à pixels émissifs selon les principes précédents, le nombre des diodes électroluminescentes dans les groupes étant choisi pour que, compte tenu du nombre de groupes, la taille du pixel soit celle des pixels de l'écran

Ainsi, on change de technologie et on bénéficie des avantages des diodes y compris en premier lieu des micro-LEDs, mais on conserve la résolution de l'ancien écran, et on est donc en mesure de satisfaire les impératifs des compagnies exploitantes, des constructeurs et des autorités de régulation. Ce résultat remarquable est obtenu grâce aux couches formant couverture communes aux diodes d'un groupe, au fait qu'il y a au moins deux diodes par groupe, et au fait que les couvertures relaient une lumière diffuse.

L'invention fournit aussi un procédé d'industrialisation d'un aéronef, comprenant une étape de qualification réglementaire menée alors qu'un exemplaire de l'aéronef aux fins de la qualification est équipé d'un écran à cristaux liquides avec rétroéclairage, et une étape ultérieure de mise en place, dans un exemplaire de l'aéronef aux fins de livraison pour exploitation, d'un écran de résolution identique à la résolution dudit écran à cristaux liquides, cet écran ayant fait l'objet d'une qualification en lui-même. L'écran de résolution identique est choisi comme un écran à pixels émissifs selon l'invention, le nombre des diodes électroluminescentes dans les groupes étant choisi pour que, compte tenu du nombre de groupes, la taille du pixel soit celle des pixels de l'écran à cristaux liquides avec rétroéclairage. De manière générale, l'invention permet aussi de donner de la souplesse au concepteur dans le cadre d'une nouvelle conception.

Il est également proposé un procédé d'adaptation d'un écran d'affichage de poste de pilotage d'un aéronef selon l'invention. Il comprend une étape de cartographie de la puissance lumineuse potentielle de l'écran à la date de l'adaptation, qui peut suivre immédiatement la fabrication du module, puis, en fonction des zones de plus faible puissance lumineuse identifiées sur l'écran, une modification de la commande de l'écran par augmentation de la puissance émise par les diodes d'un desdits groupes de diodes de l'écran correspondant à une zone de plus faible puissance lumineuse, aux fins de compenser une faiblesse d'une des diodes dudit groupe par les autres diodes du groupe. A l'inverse, on peut aussi diminuer la puissance des diodes plus fortes. Ainsi la solution permet de gérer le cas d'une micro-LED donnée en panne par un réglage sur les autres micro-LEDs de son groupe. Ceci peut être réalisé en usine lors de la calibration de l'écran, ou ultérieurement, lors d'un entretien. Ainsi, l'invention permet d'utiliser une redondance de LEDs en cas de défaillance d'un composé individuel. Un pixel coloré repose en effet sur plusieurs micro-LEDs, ce qui permet de gérer la défaillance d'une micro-LED donnée, en augmentant volontairement la puissance lumineuse générée par les autres, pour compenser la puissance perdue du fait de la défaillance.

### Brève description des dessins

L'invention sera mieux comprise et d'autres avantages apparaîtront à la lecture de la description qui va suivre donnée à titre non limitatif et grâce aux figures annexées parmi lesquelles :
La figure 1 est une vue d'un agencement initial de micro-LEDs selon deux modes de réalisation de l'invention.
Les figures 2A et 2B sont des vues de coupe d'une des réalisations de la figure 1, dans deux variantes.
La figure 3 est une représentation d'une variante de réalisation.
Les figures 4 et 5 sont des représentations de deux procédés selon l'invention.

### Description détaillée des dessins

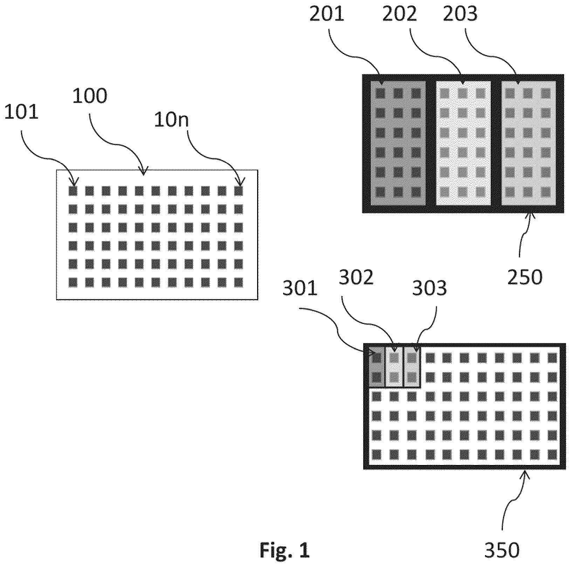

[Fig. 1] La FIGURE 1 montre un support 100, qui est un objet rigide ou semi-rigide plan à deux faces, d'épaisseur constante (ou substrat plan) portant des micro-LEDs 101, ... 10n disposées suivant un réseau à maille rectangulaire, ou un damier sur l'une de ses faces. Les micro-LEDs 101, ... 10n sont de géométrie carrée, vu de dessus. Elles sont séparées les unes des autres par une distance qui est du même ordre de grandeur que leur dimension, ou un peu plus faible. Sur la figure, les micro-LEDs 101, ... 10n sont au nombre de, dans une disposition à maille rectangulaire, 11 par 6, soit 66 micro-LEDs. Il s'agit de micro-LEDs bleues, connues pour leur bonne efficacité énergétique. Elles émettent une lumière avec un pic de longueur d'onde relativement fin, menant à cette couleur bleue.

Les micro-LEDs 101, ... 10n ont été déposées sur la surface du support 101 par transfert de masse, impliquant leur découpe par laser sur un substrat initial, puis leur transfert depuis le substrat initial, grâce à une couche de séparation et un tampon élastomère ou une autre solution de transfert de masse. Chaque micro-LED peut avoir un côté de l'ordre de 100 µm, et être séparée de la suivante, dans la direction d'alignement, d'un espace de 100 µm.

La figure 1 propose deux manières d'utiliser le support 100, en déposant sur la face qui porte les micro-LEDs, des plaques qui, pour certaines, convertissent la puissance lumineuse des micro-LEDs bleues en puissance lumineuse avec un autre pic de longueur d'onde, correspondant à une lumière verte ou rouge, notamment.

Dans une première réalisation, présentée en partie supérieure droite de la figure, des plaques 201, 202 et 203 rectangulaires sont choisies pour recouvrir 3x6 micro-LEDs (agencement compact rectangulaire) et elles sont placées sur le support 100, les unes à côté des autres, et vue de dessus comme cela est proposé sur la figure, séparées par un dépôt de matériau à forte densité optique (dit black matrix). Deux rangées de 6 micro-LEDs sont recouvertes, incidemment, par le matériau à forte densité optique.

La plaque 201 est, dans un mode de réalisation, une couverture à base de résine synthétique chargée de points quantiques rouges (même si, s'agissant de la charge, des solutions moins sophistiquées sont possibles, notamment l'utilisation de phosphores) ininterrompue et homogène au-dessus des 3x6 micro-LEDs qu'elle recouvre. La plaque 202 est une couverture également à base de résine synthétique chargée de points quantiques verts (ou éventuellement de phosphores), également ininterrompue et homogène au-dessus des 3x6 micro-LEDs qu'elle recouvre. Les plaques 201 et 202 ont, de par leur nature et leur épaisseur réduite, une fonction de transmission de puissance lumineuse, et de par leur charge chimique ou physico-chimique, une fonction de modification du spectre de la lumière en la concentrant autour d'une longueur d'onde particulière. De par le choix de l'utilisation de points quantiques, il s'agit donc de composants photoluminescents. Elles ont aussi, de par leur constitution fondée notamment sur une disposition et configuration diffusante des points quantiques dans la couverture, une fonction de diffusion de la lumière transmise, ce qui a pour conséquence que leur surface au-dessus des espaces entre deux micro-LEDs est sensiblement autant source de lumière transmise et diffuse que leur surface directement au-dessus d'une micro-LED donnée, et avec une répartition angulaire également similaire, et idéalement uniforme. L'observateur ne distingue pas individuellement les micro-LEDs qu'elle recouvre, leur intensité lumineuse étant diffuse et répartie sur toute la surface de la plaque 201 ou de la plaque 202. Ainsi, les micro-LEDs sont relayées par la couverture associée, qui modifie le spectre de la lumière et la diffuse angulairement. Les micro-LEDs sont essentiellement une source de puissance lumineuse et leur lumière est relayée par la couverture.

Les points quantiques se comportent comme des sources et émettent dans toutes les directions, de manière aléatoire.

Dans le sous-pixel coloré bleu, la lumière n'est pas émise par photoluminescence mais pas un mécanisme de diode électroluminescente, celui-ci intervient dans une direction privilégiée.

Macroscopiquement, la lumière des sous-pixels vert et rouge est donc diffuse alors que celle du bleu pourrait être directive. Afin que le mélange des couleurs résultant perçu ne dépende pas de l'angle d'observation, il a été choisi de rendre le sous-pixel bleu diffus, comme les sous-pixels vert et rouge.

La plaque 203 est ininterrompue et homogène au-dessus des 3x6 micro-LEDs qu'elle recouvre et est formée par un matériau diffusant - basé sur une résine synthétique à nouveau, par exemple la même résine synthétique que celle qui est utilisée pour les plaques 201 et 202- quant à lui sans charge photoluminescente - il ne modifie pas le spectre en longueur d'onde et conserve donc inchangé le bleu émis par les micro-LEDs - qui est choisi pour que la surface au-dessus des espaces entre deux micro-LEDs soit sensiblement autant source de lumière transmise et diffuse que la surface directement au-dessus d'une micro-LED donnée, et avec à nouveau une répartition angulaire également similaire, et idéalement uniforme. Ainsi, les micro-LEDs sont relayées par la couverture associée, qui diffuse angulairement la lumière et cette fois-ci conserve son spectre essentiellement inchangé.

Les plaques 201, 202 et 203 sont de préférence construites pour que la diffusion angulaire soit proche voire la même (on cherche à s'approcher d'une source lumineuse orthotrope ou source lumineuse lambertienne). La plaque 203 laisse donc passer une lumière bleue, à l'instar des micro-LEDs sous-jacentes, mais la lumière qu'elle émet est plus diffuse et uniforme sur une surface plus grande que la lumière émise par une seule micro-LED, et l'observateur ne distingue pas individuellement les micro-LEDs qu'elle recouvre, leur intensité lumineuse étant diffuse et répartie sur toute la surface de la plaque 203.

L'ensemble des trois plaques 201 à 203 et des micro-LEDs qu'elles recouvrent constitue un pixel coloré commandable, puisque les trois couleurs formées permettent par combinaison d'obtenir toutes les couleurs du visible par synthèse additive, et les 66 micro-LEDs sont donc commandées de manière à fournir la couleur et la luminosité voulue pour un pixel de cette taille, qui correspond à une résolution sous-optimale compte tenu de la petite taille des micro-LEDs, mais qui peut être tout à fait similaire à la résolution obtenue avec des technologies plus anciennes, comme les écrans à LCD et rétroéclairage.

Dans une deuxième réalisation, présentée en partie inférieure droite de la figure, des couvertures constituées par des plaques 301, 302 et 303 rectangulaires sont choisis pour recouvrir 1x2 micro-LEDs (agencement compact rectangulaire) et ils sont placés sur le support 100, les uns à côté des autres, séparés, en vue du dessus, par un fin dépôt du matériau à forte densité optique (dit black matrix) 350, cette matière entourant à nouveau le support autour des 66 LEDs. Il résulte de cet arrangement qu'un pixel pouvant atteindre un mélange des trois couleurs est constitué par six micro-LEDS, arrangées selon une disposition 2x3. Et le support 100 offre la place pour installer neuf pixels, occupant un espace 9x6.

Les diodes sont commandées par variation d'intensité ou modulation de largeur d'impulsion (Pulse-Width Modulation), pour au final, modifier une puissance moyenne sur une unité de temps.

Le matériau à forte densité optique permet de s'assurer que quand les micro-LEDs associée à une couleur sont allumée, leur lumière ne contamine pas la couverture voisine, associé à une autre couleur. Dans l'hypothèse où le matériau à forte densité optique est placé à la verticale de certaines micro-LEDs, ce qui est le cas pour la disposition du haut à droite de la figure 1, dans un mode de réalisation, les micro-LEDs cachées ne sont pas commandées et restent éteintes.

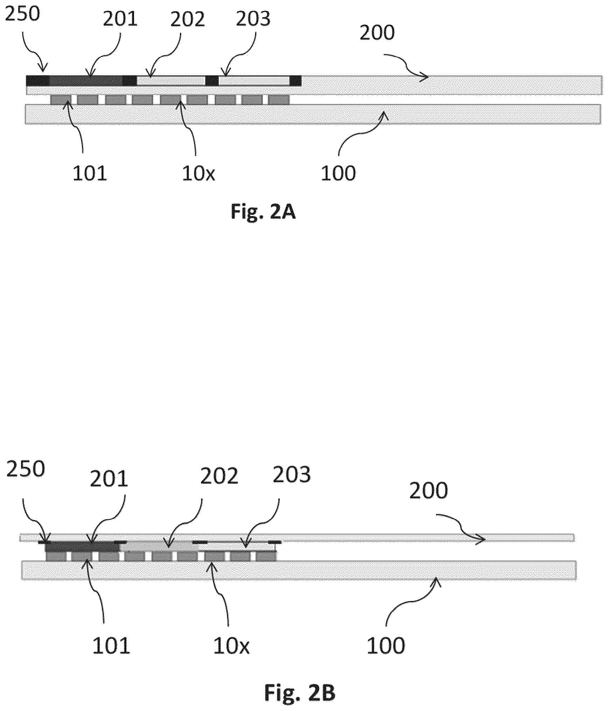

[Fig. 2A] La figure 2A montre un mode de fabrication des structures de la figure 1. Elle montre que les micro-LEDs sont présentes à la surface du support 100, et qu'est posé sur les micro-LEDs une feuille de verre 200 dans l'épaisseur de laquelle ou à la surface de laquelle sont installées les plaques 201 et 202 constituant chacune une couverture photoluminescente et la plaque 203 constituant une couverture diffusante, et qui peuvent être fines, notamment plus fines que la feuille de verre 200. Les plaques 201 et 202 sont déposées par exemple par jet d'encre ou sérigraphie d'un polymère ou d'une résine synthétique dans lequel les points quantiques (ou des compositions dites « phosphore ») sont mélangés. La plaque 203 est déposée par exemple par la même méthode, sous la forme d'un dépôt d'une résine synthétique ou d'un polymère initialement fluide et contenant une poudre diffusante.

Un matériau à forte densité optique 250 comble les espaces entre les zones formant les sous-pixels et masque ainsi les métallisations et le substrat présent entre les micro-LEDs. Il peut aussi prendre la forme d'une résine synthétique ou d'un polymère, comprenant un pigment noir ou très sombre.

Néanmoins le matériau à forte densité optique 250 peut être un dépôt métallique, sans résine ou polymère, auquel cas, il peut être déposé sous la forme d'un oxyde métallique par pulvérisation ou évaporation, notamment avant le dépôt par impression jet d'encre des plaques 201, 202 et 203. Il est alors plus fin que les couches de résine ou polymère. Il peut notamment comprendre un oxyde de chrome ou du molybdène.

Le dépôt des trois plaques 201, 202 et 203 ainsi que du matériau à forte densité optique est effectué par exemple dans une unique surface amincie rectangulaire de la feuille de verre. Sur cette figure les couvertures constituées par les plaques 201 et 202 et la couverture constituée par la plaque 203 sont présentes sur la face de la feuille de verre 200 qui est tournée du côté opposé aux LEDs 101 ...1 0x, mais il est aussi possible que les couvertures tout en ayant été déposées sur la feuille de verre 200, soient présentes sur la face de celle-ci tournée vers les LEDs 101, ... 10x, et entrent donc, au moment de l'assemblage, en contact avec la face externe de celles-ci. En tout état de cause, le dépôt des couvertures et du matériau à forte densité optique est dans cette variante effectué sur une surface plane continue de la plaque de verre, mais la plaque de verre peut aussi présenter des reliefs éventuellement, tout en étant en général non trouée.

Alternativement à cette structure, il est aussi mis en oeuvre des variantes.

[Fig. 2B] En figure 2B, la composante colorée a été déposée sur la partie supérieure des diodes. La feuille de verre a reçu le matériau à forte densité optique 250, et est déposée sur l'ensemble composé des diodes et des couvertures. Plus précisément, les couvertures étant constitués d'un polymère ou d'une résine synthétique, elles sont déposés sur le haut des diodes, bien que des espaces vides soient présents entre les diodes. La viscosité et l'épaisseur du matériel déposé est suffisante pour que le matériel déposé forme une couche continue formant des ponts du haut d'une diode au haut de la diode suivante, et que la couche soit homogène et plane malgré le relief sur lequel elle a été déposée.

Le matériau à forte densité optique 250 quant à lui a été déposé par évaporation ou pulvérisation d'oxydes métalliques sur la plaque de verre, ou par dépôt d'une résine chargée d'une poudre noire. Lors du rapprochement de la feuille de verre portant le matériau à forte densité optique et les couvertures, on s'assure du bon alignement des séparations entre les éléments colorés et les lignes de matériau à forte densité optique.

La feuille de verre peut recevoir un plan métallique pour écrantage de type blindage électromagnétique (recherchant la compatibilité électromagnétique - CEM). Une telle grille métallique vient fermer une cage métallique de l'unité portant l'écran, et former ainsi une cage de Faraday qui protège le contenu de l'unité.

Elle peut recevoir un traitement anti-reflet.

Elle est reliée au support 100, sur la face de celui-ci portant les LEDs 101, ... 10x, par exemple par une colle optique qui polymérise, entre les LEDs et les couvertures, ou si les couvertures ont été placées sur les LEDs initialement, entre les couvertures et le verre.

Le support 100 comprend des transistors à couches minces TFT ou un circuit CMOS ou un autre substrat de microélectronique, et est fixé à un bâti mécanique, formant un châssis qui porte aussi les cartes électroniques de commande des diodes.

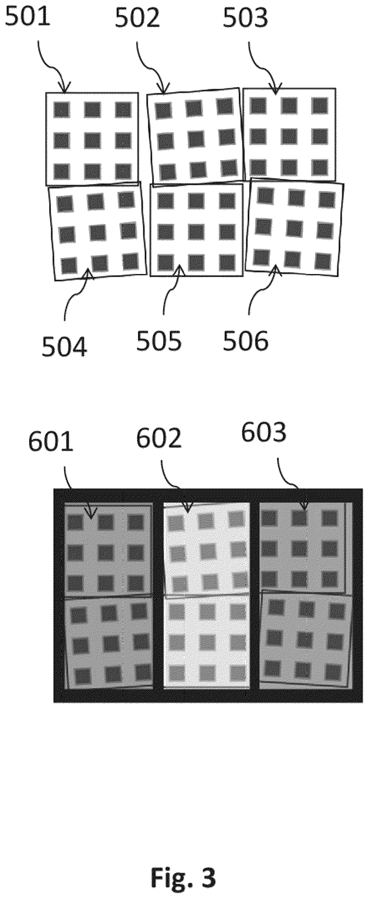

[Fig. 3] La figure 3 montre un mode de réalisation dans lequel les micro-LEDs sont portées par des supports carrés de petite taille qui en accueillent 9, selon une disposition 3x3. Il est choisi d'utiliser des couvertures constituées par des plaques 601 et 602 actives (avec changement de longueur d'onde de la lumière, par photoluminescence) et 603 passives (sans photoluminescence) ayant chacune une émission angulaire lambertienne, de forme rectangulaire et de dimension choisie pour recouvrir deux carrés correspondant à 9 micro-LEDs chacune, placé l'un à côté de l'autre, pour former ainsi trois sources de lumière colorée juxtaposée comme dans la structure de la partie supérieure de la figure 1. Ainsi on a utilisé 6 supports 501 - 506 pour trois plaques 601-603. Dans une telle circonstance, le fait que les supports ne soient pas positionnés sur un support sous-jacent, de manière totalement contrôlé, à quelques degrés d'angles prés, ou à quelques micromètres près en translation, est surmonté visuellement une fois que les plaques 601-603 sont posées, puisque les imperfections angulaires sont masquées par les plaques.

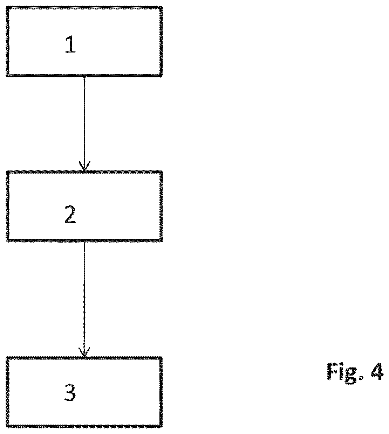

[Fig. 4] En figure 4 on a représenté un procédé selon l'invention. Au cours d'une étape 1, on dépose un écran à cristaux liquides, ou un écran à diodes électroluminescentes à technologie émissive, présent dans la planche de bord d'un aéronef, et qui nécessite un remplacement, pour cause d'obsolescence ou de panne, ou d'évolution proposée à l'opérateur.

Au cours d'une étape 2, on identifie une configuration d'écran à micro-LEDs conformes aux principes de l'invention qui offre la même résolution que l'écran déposé, quelle que soit la technologie de celui-ci.

Pour cela, on dispose d'un stock de supports rectangulaires ou carrés de micro-LEDs comportant des micro-LEDs disposés sur une surface du support.

Le support a des dimensions dans les deux dimensions du plan. De plus les micro-LEDs sont disposés sur la surface du support avec une densité donnée et connue. Sur cette base, on choisit en fonction de la taille des pixels souhaitée, de dimensionner les plaques colorées qui vont être placées au-dessus des micro-LEDs pour qu'elles recouvrent un nombre approprié de micro-LEDs, prises sous la forme d'un rectangle de n × m micro-LEDs, avec au moins n ou m supérieur ou égal à 2.

En étape 3, on met en place l'écran à micro-LEDs à la place de l'écran à LCD. Il reçoit le même flux vidéo que l'écran précédent, qui est typiquement un flux vidéo numérique transféré par un bus de données par exemple au format LVDS, avec une résolution 1 920 × 1 080 pixels, et un rafraichissement de 50 à 60 Hz.

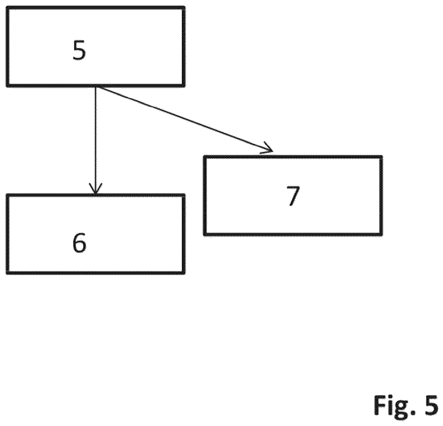

[Fig. 5] En figure 5, on a représenté un autre procédé selon l'invention. On précise aussi que la structure qui est proposée permet aussi de compenser les éventuelles micro-LEDs défectueuses, puisque les micro-LEDs sont regroupées en groupe de plusieurs micro-LEDs et qu'il est donc possible de compenser la panne d'une micro-LEDs (détectée en cartographiant la luminance pur détecter des anomalies) en imposant une lumière plus importante aux micro-LEDs placées sous la même plaque, par la commande qui leur est transmise, voire en activant des micro-LEDs non utilisées jusque-là et conservées comme réserve pour les pannes.

Ainsi, au cours d'une étape 5 de cartographie de différents systèmes d'affichage similaires d'un parc de systèmes d'affichage, on identifie ceux qui ont besoin d'une modification de l'affichage du fait de la panne de certaines micro-LEDs, et à partir de ce diagnostic, on maintient inchangé (étape 6) la commande appliquée aux écrans sans défaut, et on modifie (étape 7) la commande appliquée aux écrans pour lesquels il a été constaté qu'une ou plusieurs micro-LEDs était défectueuse, pour compenser par les micro-LEDs voisines qui sont sous la même plaque, la perte d'intensité lumineuse de la ou des micro-LEDs défectueuses.

De manière générale, on a envisagé dans le texte des micro-LEDs bleues comme éléments constitutifs du système, mais des micro-LEDs violettes sont utilisées dans une variante. Par ailleurs, la feuille de verre 200 peut être dans un autre matériau laissant passer les longueurs d'onde concernées, notamment un matériau flexible, de nature polymérique.

On a présenté des écran offrant une large gamme de couleurs par synthèse additive, pour chaque pixel, de trois sources colorées, l'une bleue, l'autre rouge et la troisième verte, constituant chacune un sous-pixel. Mais l'écran peut alternativement être un écran monochrome d'unité de contrôle de vol, dans lequel chaque pixel comprend un unique sous-pixel, avec une unique couleur, qui peut être le vert. Dans ce cas et dans un mode de réalisation, on utilise à nouveau des micro-LEDs bleues, et cette fois on leur adjoint un phosphore vert ou un point quantique vert dans une couverture commune à plusieurs micro-LEDs pour la conversion de longueur d'onde et la diffusion. Dans ce cas on a un seul type de pixel composé d'un certain nombre de micro-leds bleues et d'un élément fluorescent vert, couche ou plaque, recouvrant le groupe de micro-LEDs, et se comportant comme une unique source de lumière, du fait du caractère diffus de la lumière qu'il relaie.

Les plaques formant couverture ont été décrites comme constituée de résine synthétique ou polymère, incluant dans le volume formant une couche d'une certaine épaisseur une dispersion de points quantiques ou de poudre dispersante, la résine restant présente pendant la vie du produit. Alternativement, la fonction de couverture peut être obtenue par le dépôt des points quantiques ou de la poudre dispersante sur une surface plane - la surface de la feuille de verre - dans un solvant qui s'évapore après dépôt, et qui ne laisse donc qu'un fin dépôt de faible épaisseur, le solvant ayant disparu. Le dépôt est plan et homogène.

Alternativement, les plaques formant couverture sont formées par un dépôt de granulés de phosphore sur la feuille de verre. Le dépôt est plan et homogène.

## Revendications

1. Ecran à pixels émissifs pour poste de pilotage d'aéronef, comprenant un substrat plan portant une pluralité de diodes électroluminescentes de même spectre d'émission (101, ... 10n) et dans lequel chaque pixel est constitué d'au moins un groupe compact de plusieurs desdites diodes électroluminescentes, l'écran étant **caractérisé en ce que** dans un pixel de l'écran, les diodes électroluminescentes du groupe de diodes sont recouvertes d'une couche (201, 202, 203) formant une couverture commune auxdites diodes électroluminescentes dudit groupe de diodes et relayant une lumière diffuse, avec ou sans photoluminescence, en réaction à l'émission de lumière par les diodes électroluminescentes du groupe.

2. Ecran à pixels émissifs selon la revendication 1, **caractérisé en ce que** la couche (201, 202) comprend des points quantiques de sorte que la lumière diffusée est de longueur d'onde plus élevée que la lumière reçue des diodes électroluminescentes et que la couche (201, 202) a une émission lumineuse étendue angulairement.

3. Ecran à pixels émissifs selon la revendication 1 ou la revendication 2, **caractérisé en ce que** le pixel comprend plusieurs groupes de diodes électroluminescentes, et pour chaque groupe de diodes du pixel, une couche (201, 202, 203) de propriété colorimétrique spécifique recouvre les diodes électroluminescentes dudit groupe formant une couverture propre à chacun des groupes.

4. Ecran à pixels émissifs selon la revendication 3, **caractérisé en ce que** la couche (203) de l'un desdits plusieurs groupes de diodes comprend une charge diffusante et est sans propriété photoluminescente.

5. Ecran à pixels émissifs selon l'une des revendications 1 à 4, **caractérisé en ce que** les diodes électroluminescentes (101, ... 10n) sont des diodes à base de nitrure de galium dites micro-LEDs de spectres d'émission identiques.

6. Ecran à pixels émissifs selon l'une des revendications 1 à 5, **caractérisé en ce que** chaque groupe de diodes est constitué par le rapprochement de substrats rectangulaires (501-506) de diodes électroluminescentes comprenant des diodes en plusieurs rangées de diodes.

7. Ecran à pixels émissifs selon l'une des revendications 1 à 6, **caractérisé en ce qu'**un matériau à forte densité optique (250) est placé entre les groupes de diodes.

8. Ecran à pixels émissifs selon l'une des revendications 1 à 7, **caractérisé en ce que** la couche forme un encapsulage des diodes, ou est placée sur une couche de verre collée aux diodes.

9. Procédé de remplacement d'un écran d'affichage de poste de pilotage d'un aéronef, comprenant une étape de dépose (1) d'un écran à cristaux liquides avec rétroéclairage, et une étape de remplacement (3) dudit écran par un écran de résolution identique à la résolution dudit écran à cristaux liquides, **caractérisé en ce que** l'écran de résolution identique est choisi (2) comme un écran à pixels émissifs selon l'une des revendications précédentes, le nombre des diodes électroluminescentes dans les groupes étant choisi pour que, compte tenu du nombre de groupes, la taille du pixel soit celle des pixels de l'écran à cristaux liquides avec rétroéclairage.
